(19) Europäisches Patentamt
European Patent Office
Office européen des brevets

(11) **EP 2 816 722 B1**

(12) **EUROPEAN PATENT SPECIFICATION**

(45) Date of publication and mention
of the grant of the patent:
**21.11.2018 Bulletin 2018/47**

(51) Int Cl.:
*H02M 7/5387* $^{(2007.01)}$     *H02M 1/32* $^{(2007.01)}$

(21) Application number: **14166160.3**

(22) Date of filing: **28.04.2014**

(54) **Method to estimate power dissipation of an inverter**

Verfahren zur Schätzung der Verlustleistung eines Wechselrichters

Procédé pour estimer la dissipation de puissance d'un inverseur

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **21.05.2013 US 201313899065**

(43) Date of publication of application:
**24.12.2014 Bulletin 2014/52**

(73) Proprietor: **Delphi Technologies, Inc.
Troy MI 48007 (US)**

(72) Inventor: **Krefta, Ronald J.
Nobelsville, IN 46062 (US)**

(74) Representative: **Delphi France SAS
c/o Delphi Technologies
Campus Saint Christophe
Bâtiment Galilée 2
10, avenue de l'Entreprise
95863 Cergy Pontoise Cedex (FR)**

(56) References cited:
**EP-A2- 2 398 140**

• LIXIANG WEI ET AL: "Evaluation of Power
Semiconductors Power Cycling Capabilities for
Adjustable Speed Drive", INDUSTRY
APPLICATIONS SOCIETY ANNUAL MEETING,
2008. IAS '08. IEEE, IEEE, PISCATAWAY, NJ,
USA, 5 October 2008 (2008-10-05), pages 1-10,
XP031354086, ISBN: 978-1-4244-2278-4
• Dusan Graovac, Marco Pürschel, Andreas Kiep:
"MOSFET Power Losses Calculation Using the
Data-Sheet Parameters", Infineon Technologies
AG , 31 July 2006 (2006-07-31), XP002736264,
Retrieved from the Internet:
URL:https://www.btipnow.com/library/white_
papers/MOSFET%20Power%20Losses%20Calc
ulati
on%20Using%20the%20Data-Sheet%20Paramet
ers .pdf [retrieved on 2015-02-20]
• AHMET M HAVA ET AL: "Carrier-Based PWM-VSI
Overmodulation Strategies: Analysis,
Comparison, and Design", IEEE TRANSACTIONS
ON POWER ELECTRONICS, INSTITUTE OF
ELECTRICAL AND ELECTRONICS ENGINEERS,
USA, vol. 13, no. 4, 1 July 1998 (1998-07-01),
XP011043188, ISSN: 0885-8993

**Description**

**TECHNICAL FIELD OF INVENTION**

This disclosure generally relates to method to estimate power dissipation of an inverter configured to control electric energy to an electric machine, and more particularly relates to determining a correction factor (CF) for the estimate of power dissipation based on a modulation index (MI) of the inverter a power factor (PF) of the electric machine.

**BACKGROUND OF INVENTION**

Knowing the power dissipation by power devices of inverter systems used to drive electric machines or electric motors of hybrid vehicles (HEV) and electric vehicles (EV) is useful to estimate device temperature and determine a current limit of current supplied by the inverter to the electric motor. Power dissipation is typically calculated from equations that calculate the forward conduction power loss and the associated switching losses for both power transistors and antiparallel diodes of the inverter. However, when the inverter is operated in the non-linear or over-modulation region of operation, the accuracy of the switching losses deteriorates greatly as one approaches six-step operation. The document LIXIANG WEI et al "Evaluation of Power Semiconductors Power Cycling Capabilities for Adjusting Speed Drive" Inductrial Applications Society Annual Meeting, 2008. IAS '08 Piscataway, NJ, USA 5 October (2008-10-05) XP031354086 describes the power cycling capabilities of semiconductors.
The paper by Dusan Graovac, Marco Purschel, Andreas Kiep "MOSFET Power losses Calculation Using the Data -Sheet parameters" Infineon Technologies AG 31 July 2006 describes method of determining MOSFET power losses.
The paper by Ahmet M Hava et al "Carrier Based PWM-VSI Overmodulation Strategies: Analysis, Comparison, and Design" IEEE Transaction on Power Electronics, IEEE, USA vol. 13, no. 4, 1 July 1998 XP011043188 investigates overmodulation region voltage gain characteristics of PWM methods.
EP Patent Application EP 2398140 describes methods of operating an inverter.

**SUMMARY OF THE INVENTION**

Conductive losses are typically calculated based on a power factor (PF) of the electric machine, a modulation index (MI) of the inverter, a machine current, and power device (e.g. transistor, diode) voltage drop and resistance parameters. The switching losses are typically calculated based on a pulse-width modulation (PWM) frequency of the inverter, a DC supply voltage (VS) of the inverter, the machine current, a power transistor turn-on and turn-off energy per volt-amp characteristic, and a diode reverse recovery energy per volt-amp characteristic.

Preferably, for reasons of computational efficiency, these losses are calculated in a relatively slow loop of software operating the inverter and assuming a sine-triangle modulation. A slow loop is characterized as having a longer software loop time than would be the case for a relatively fast loop such as a loop based on the PWM frequency. The switching losses are calculated in a relatively accurate manner over the linear range of operation. However, when the inverter is operated in the over-modulation region of operation, the accuracy of the switching losses deteriorates greatly as one approaches six-step operation. Described herein is a method or algorithm that can be used to reduce error in the calculation or estimation of power dissipation by the power devices (e.g. transistor and/or diode) when an inverter is being operated in the non-linear or over-modulation region of operation.

In accordance with one embodiment, a method to estimate power dissipation of an inverter configured to control electric energy to an electric machine is provided. The power dissipation includes conductive power losses and switched power losses. The method includes the step of determining a switched transistor power (PSQ) of a transistor. The PSQ is based on a modulation frequency (FM), a peak transistor current (IPQ) of current through the transistor, a rail-to-rail inverter supply voltage (VS), and a transistor switching energy (ESQ) of the transistor for each modulation cycle. The method also includes the step of determining a modulation index (MI) of the invertor. The method also includes the step of determining a power factor (PF) of the electric machine. The method also includes the step of determining a correction factor (CF) for the PSQ. The CF is set to one (1) if the MI is not greater than a threshold, and the CF is based on the MI and the PF if the MI is greater than the threshold. The method also includes the step of estimating power dissipation of the transistor based on the PSQ and the CF. The transistor may be one of an insulated gate bipolar transistor (IGBT), and a metal oxide semiconductor field effect transistor (MOSFET). The switched transistor power (PSQ) is determined by the equation $PSQ = FM \cdot IPQ \cdot ESQ \cdot VS / \pi$. The modulation index (MI) may be determined by the equation $MI = (\pi / \sqrt{2}) * (VP/VS)$, where VP is an AC RMS voltage applied to the electric machine by the inverter, and VS is a rail-to-rail supply voltage of the inverter. The correction factor (CF) may be determined by the equation $CF = 8.752 - 8.5933*MI - 0.2280*|PF|$ if the MI is greater than the threshold. In a preferred embodiment, the method further includes the step of determining a conductive transistor power (PCQ) of the transistor based on a saturation voltage (VSQ) of the transistor, an on-resistance (ROQ) of the transistor, and current through the transistor. The step of estimating power dissipation of the transistor may be based on the PCQ. In a preferred embodiment, the method further includes the step of determining a switched diode power (PSD) of a diode connected in parallel with the transistor, wherein the PSD may be based on a modulation frequency (FM), a peak diode current (IPD) of current through the diode, a rail-to-rail inverter supply voltage (VS), and a diode reverse-recovery energy (ERD) of the diode for each modulation cycle. The method may further include the step of estimating power dissipation of the diode based on the PSD and the CF. The switched diode power (PDS) may be determined by the equation $PSD = FM \cdot IPD \cdot ERD \cdot VS / \pi$. The method may further include the step of determining a conductive diode power (PCD) of the diode based on a diode saturation voltage (VSD), an on-resistance of the diode 24 (ROD), and current through the diode. The power dissipation of an inverter may be based on the power dissipation of the transistor and the power dissipation of the diode. In another embodiment, a method to estimate power dissipation of an inverter configured to control electric energy to an electric machine is provided. The power dissipation includes conductive power losses and switched power losses. The method includes the step of determining a switched diode power (PSD) of a diode based on a modulation frequency (FM), a peak diode current (IPD) of current through the diode, a rail-to-rail inverter supply voltage (VS), and a diode reverse-recovery energy (ERD) of the diode for each modulation cycle. The method also includes the step of determining a modulation index (MI) of the invertor. The method also includes the step of determining a power factor (PF) of the electric machine. The method also includes the step of determining a correction factor (CF) for the PSD. The CF is set to one (1) if the MI is not greater than a threshold, and the CF is based on the MI and the PF if the MI is greater than the threshold. The method also includes the step of estimating power dissipation of the diode based on the PSD and the CF. The switched diode power (PSD) may be determined by the equation $PSD = FM \cdot IPD \cdot ERD \cdot VS / \pi$. The modulation index (MI) is determined by the equation $MI = (\pi / sqrt(2))$ * (VP/VS), where VP is an AC RMS voltage applied to the electric machine by the inverter, and VS is a rail-to-rail supply voltage of the inverter. The correction factor (CF) may be determined by the equation $CF = 8.752 - 8.5933*MI - 0.2280*|PF|$ if the MI is greater than the threshold. In a preferred embodiment the method also further includes the step of determining a switched transistor power (PSQ) of a transistor connected in parallel with the diode, wherein the PSQ may be based on a modulation frequency (FM), a peak transistor current (IPQ) of current through the transistor, a rail-to-rail inverter supply voltage (VS), and a switching energy (ES) of the transistor for each modulation cycle. The method may also further include the step of estimating power dissipation of the transistor based on the PSQ and the CF. The transistor may be one of an insulated gate bipolar transistor (IGBT), and a metal oxide semiconductor field effect transistor (MOSFET). The switched transistor power (PSQ) may be determined by the equation $PSQ = FM \cdot IPQ \cdot ESQ \cdot VS / \pi$.

In a preferred embodiment an apparatus adapted to measure the power dissipation of an inverter is provided. The inverter is configured to control electric energy to an electric machine is provided. The inverter comprises, means for determining a switched power of a transistor or a diode, said switched power (PSQ, PSD) being based on a modulation frequency (FM), a peak current (IPQ, IPD) of current through the transistor or the diode, a rail-to-rail inverter supply voltage (VS), and an switching energy (ESQ, ERD) of the switched transistor or the switched diode for each modulation cycle. The invertor further comprises means for determining a modulation index (MI) of the invertor. The invertor further comprises means for determining a power factor (PF) of the electrical machine. The invertor further comprises means for determining a correction factor (CF) for the PSQ or the PSD, wherein the CF is set to one (1) if the MI is not greater than a threshold, and the CF is based on the MI and the PF if the MI is greater than the threshold. The invertor further comprises means for estimating power dissipation of the transistor or the diode based on the PSQ or the PSD and the CF.

Further features and advantages will appear more clearly on a reading of the following detailed description of the preferred embodiment, which is given by way of non-limiting example only and with reference to the accompanying drawings.

## BRIEF DESCRIPTION OF DRAWINGS

The present invention will now be described, by way of example with reference to the accompanying drawings, in which:

Fig. 1 is a diagram of an inverter in accordance with one embodiment; and
Fig. 2 is flowchart of a method of operating the inverter of Fig. 1 in accordance with one embodiment.

## DETAILED DESCRIPTION

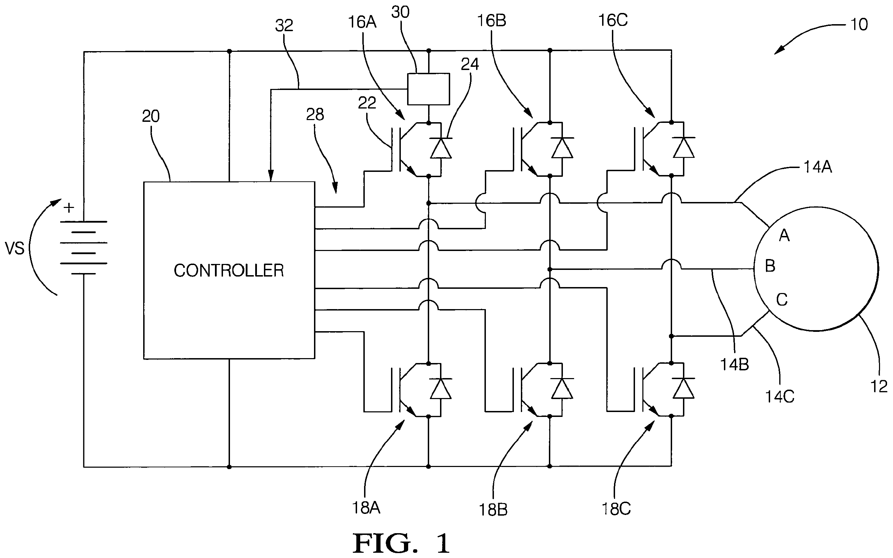

Fig. 1 illustrates a non-limiting example of an inverter 10 configured to control electric energy to an electric machine 12, such as an electric motor used to propel a hybrid automobile (not shown). The term inverter is commonly used to describe a circuit that converts a relatively steady direct-current (DC) type voltage into an alternating-current (AC) type signal, for example a sinusoidal AC signal. Such a circuit may alternatively be referred to as motor drive circuit or a motor driver. In this non-limiting example the inverter 10 is configured to control three phases of the electric machine: phase-A 14A, phase-B 14B, and phase-C 14C. However, it is contemplated that the teachings set forth herein are also applicable to inverters coupled to electric machines that have alternative phase numbers, such a five or seven phase AC machines; only two phases, such as a brush-type direct current motor or a solenoid; or even a single phase application where one end of a two-phase electric machine is permanently coupled to, for example, electrical ground. In this non-limiting example, the inverter 10 has a high-side-driver for each phase: high-side-drive-A (HSDA) 16A for coupling phase-A 14A to the high side of a supply voltage VS of the inverter 10; high-side-drive-B (HSDB) 16B for coupling phase-B 14B to the high side of a supply voltage VS of the inverter 10; and high-side-drive-C (HSDC) 16C for coupling phase-A 14C to the high side of a supply voltage VS of the inverter 10. The inverter 10 may also include corresponding low-side-drivers (LSD) for each phase, e.g. LSDA 18A, LSDB 18B, and LSDC 18C.

Each driver (e.g. HSDA 16A, HSDB 16B, HSDC 16C LSDA 18A, LSDB 18B, and LSDC 18C) typically includes a transistor 22, such as an insulated-gate-bipolartransistor (IGBT) as shown, or a metal-oxide-semiconductor-field-effect-transistor (MOSFET). The transistor 22 may be an N-channel or P-channel type transistor depending on the configuration of the controller 20, as will be recognized by those in the art. Each driver may also include a diode 24 that may be a separate device, or integrated into a single package with the transistor 22, or may be an inherent device as will be recognized by those familiar with MOSFETs

The inverter 10 may also include a controller 20 configured to output control signals 28 to the various high-side-driver and low-side-driver portions of the inverter 10. The controller 20 may include a processor (not shown) such as a microprocessor or other control circuitry as should be evident to those in the art. The controller 20 may include memory (not shown), including non-volatile memory, such as electrically erasable programmable read-only memory (EEPROM) for storing one or more routines, thresholds and captured data. The one or more routines may be executed by the processor to perform steps for determining signals output and received by the controller 20 for controlling electrical energy provided to the electric machine 12 as described herein.

When the various drivers are typically operated at relatively high frequencies, for example greater than one kilo-Hertz (1kHz) to, for example, synthesize a sinusoidal signal on one or more phases of the electric machine 12, it may be desirable to estimate the operating temperature of the transistor 22 and/or the diode 24 so it can be determined if continued operation of the inverter may damage the transistor 22 or the diode 24 by way of excessive operating temperature. While not subscribing to any particular theory, power losses or power dissipation by the transistor 22 and/or the diode 24 can be described in terms of conductive power losses and switched power losses. The conductive power losses and switched power losses may be added to determine a total power loss by the transistor 22 or the diode 24. Accordingly, the controller 20 may be configured to estimate power dissipation of the inverter 10 by combining the power dissipation by each of the drivers: HSDA 16A, HSDB 16B, HSDC 16C LSDA 18A, LSDB 18B, and LSDC 18C.

The inverter 10 may also be equipped with a current sensor 30 configured to determine a current value of current flowing through the HSDA 16A to aid with determining power dissipation by the transistor 22 and/or the diode 24. Only one current sensor is illustrated for the purpose of simplifying the drawing. However, it is contemplated that HSDB 16B and HSDC 16C may also be equipped with current sensors, and all of the low side drivers (18A, 18B, and 18C) may also be equipped with current sensors configured to convey current signals to the controller 20.

By way of example and not limitation, the current sensor 30 may include a current sense resistor (not shown) and a voltage sensor (not shown) so a current value can be inferred from the voltage across the current sense resistor as is well known in the electronic arts. Since in this non-limiting example current through the transistor 22 and the diode 24 are combined at the current sensor 30, a current signal 32 may need to be analyzed to determine if current is flowing through either or both of the transistor 22 and the diode 24, as will be recognized by those in the electronics arts. Alternatively, the current sensor 30 may be relocated to measure only current through the transistor 22 or only current through the diode 24, and a second current sensor (not shown) may be added so current through the transistor 22 and the diode 24 can be measured independently. Furthermore, one can envision a single current sensor measuring the phase current through the phase conductors, 14A, 14B, and 14C, for instance, as is known to those skilled in the art. Such sensors may also be inductive in nature or any of a variety of methods typically used.

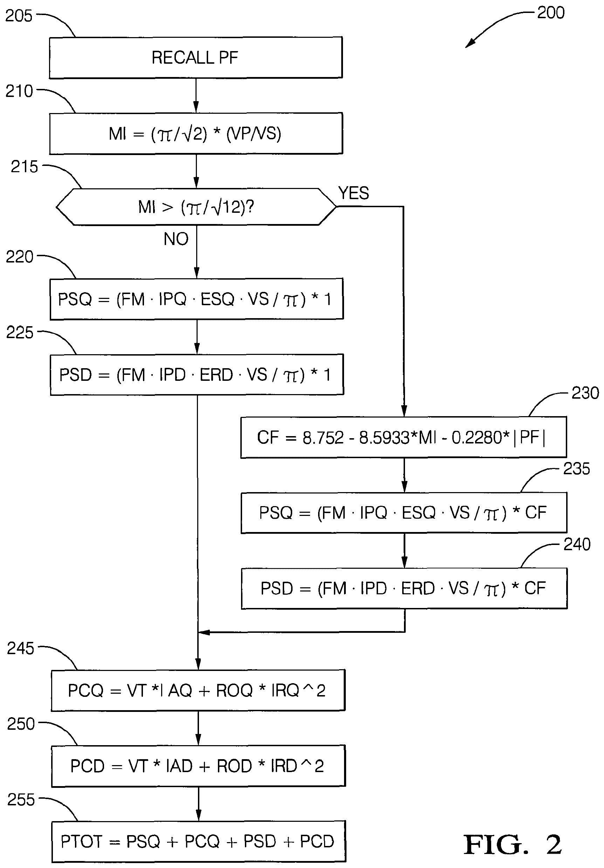

Fig. 2 illustrates a non-limiting example of a method 200 that may be executed by the controller 20 to estimate power dissipation of the inverter 10 when operated to control electric energy to the electric machine 12. As pointed out above, the power dissipation may include conductive power losses and switched power losses of the transistor 22 and/or the diode 24.

Step 205, RECALL PF, may include determining a power factor (PF) of the electric machine by, for example, recalling a predetermined power factor value of the electric machine 12 that was stored in memory (not shown) of the controller 20. The PF generally has a value between plus 1 (+1) and minus one (-1), and is a known way to characterize the reactive nature of the electrical load presented by the electric machine 12 to the inverter 10. If the electric machine 12 was a purely resistive load, the PF would be one (1).

Step 210, MI = $(\pi / \sqrt{2})$ * (VP/VS), may include determining a modulation index (MI) of the invertor, where the MI is determined by Eq. 1,

$$MI = (\pi \,/\, sqrt(2)) * (VP/VS), \qquad\qquad\qquad Eq.\ 1$$

where VP is an alternating-current (AC) root-mean-square (RMS) voltage applied to a phase (14A, 14B, 14C) of the electric machine 12 by the inverter 10 as measured by, for example, the controller 20; and VS is a rail-to-rail supply voltage of the inverter 10 as measured by, for example, the controller 20. In general, the inverter 10 is not being over-driven if VP is sinusoidal, i.e. is not clipping by requiring a sinusoidal peak voltage greater than the rail supply voltage (VS). MI has a value of one (1) when the inverter 10 is being operated in the so-called six-step mode or trapezoidal mode. It is recognized that alternative definitions of modulation index are often used and the definition chosen shall not be considered a limiting factor.

Step 215, MI > ($\pi\,/\,\sqrt{12}$)?, may include comparing the value of MI to a predetermined threshold such as pi (3.1416) divided by the square-root of twelve (3.4641), or about 0.9069. If the MI is not greater than the threshold (NO), it is an indication that the inverter 10 is not being over-modulated, i.e. is being operated in the linear region. As such, correcting or compensating the switching power calculations for the transistor 22 and/or the diode 24 is not necessary, and the method proceeds to step 220. However, If the MI is greater than the threshold (YES), it may be an indication that the inverter 10 is being over-modulated, i.e. is being operated in the non-linear region. As such, correcting or compensating the switching power calculations for the transistor 22 and/or the diode 24 is necessary, and the method proceeds to step 230.

Step 220, PSQ = (FM • IPQ • ESQ • VS / $\pi$) * 1, may include calculating or determining a switched transistor power (PSQ) of the transistor 22 using Eq. 2,

$$PSQ = FM \cdot IPQ \cdot ESQ \cdot VS \,/\, \pi * 1, \qquad\qquad Eq.\ 2$$

where FM a modulation frequency or pulse width modulation frequency of the inverter 10 or controller 20, IPQ is a peak transistor current of current through the transistor 22 measured over one or more complete AC cycles by, for example, the current sensor 30, VS is a rail-to-rail inverter supply voltage measured, for example, by a sensor (not shown) and the controller; and ESQ is the sum of the turn-on and turn-off switching energy per volt-amp of the transistor 22 for each modulation cycle. The value of ESQ is determined by from the power device manufacturer data sheet or may be predetermined by measurement and input as a calibrated parameter in the algorithm software code. The inclusion of the multiplication by one in Eq. 2 is only for the purpose of contrasting Eq. 2 with Eq. 5 presented below.

Step 225, PSD = (FM • IPD • ERD • VS / $\pi$) * 1, may include calculating or determining a switched diode power (PSD) of the diode 24 using Eq. 3,

$$PSD = (FM \cdot IPD \cdot ERD \cdot VS \,/\, \pi) * 1, \qquad\qquad Eq.\ 3$$

where FM is the modulation frequency of the inverter 10; IPD is a peak diode current of current through the diode 24 as measured over one or more complete AC cycles by, for example, the current sensor 30; VS is a rail-to-rail inverter supply voltage (VS) measured by, for example, the controller 20; and ERD is a diode reverse-recovery energy of the diode 24 for each modulation cycle. The value of ERD is determined by from the diode manufacturer data sheet or may be predetermined by measurement and input as a calibrated parameter in the algorithm software code. The inclusion of the multiplication by one in Eq. 3 is only for the purpose of contrasting Eq. 2 with Eq. 6 presented below.

Step 230, CF = 8.752 - 8.5933*MI - 0.2280*|PF|, may include calculating or determining a correction factor (CF) for the PSQ and the PSD, if the inverter is being over-modulated or operated in the non-linear region, using by way of example and not limitation, Eq. 4,

$$CF = 8.752 - 8.5933*MI - 0.2280*|PF|, \qquad\qquad Eq.\ 4$$

where the coefficients in Eq. 4 are determined empirically. Alternatively, the CF may be determined using an empirically derived look-up table stored in the memory of the controller 20. As such, the CF is effectively set to one (1) in Eq. 2 and Eq. 3 if the MI is not greater than a threshold, and the CF is based on the MI and the PF if the MI is greater than the threshold.

Step 235, PSQ = (FM • IPQ • ESQ • VS / $\pi$) * CF, may include estimating power dissipation of the transistor 22 based on the PSQ and the CF using Eq. 5,

$$PSQ = FM \cdot IPQ \cdot ESQ \cdot VS / \pi * CF, \qquad\qquad Eq. 5$$

where FM a modulation frequency or pulse width modulation frequency of the inverter 10 or controller 20, IPQ is a peak transistor current of current through the transistor 22 measured over one or more AC cycles by, for example, the current sensor 30, VS is a rail-to-rail inverter supply voltage measured, for example, by the controller; and ESQ is a transistor switching energy ESQ of the transistor 22 for each modulation cycle. The value of ESQ is determined as described above with regard to Eq. 2.

Step 240, PSD = (FM $\cdot$ IPD $\cdot$ ERD $\cdot$ VS / $\pi$) * CF, may include calculating or estimating power dissipation of the diode 24 based on the PSD and the CF using Eq. 6,

$$PSD = (FM \cdot IPD \cdot ERD \cdot VS / \pi) * CF, \qquad\qquad Eq. 6$$

where FM is the modulation frequency of the inverter 10; IPD is a peak diode current of current through the diode 24 as measured by, for example, the current sensor 30; VS is a rail-to-rail inverter supply voltage (VS) measured by, for example, the controller 20; and ERD is a diode reverse-recovery energy of the diode 24 for each modulation cycle. The value of ERD is determined as described above with regard to Eq. 3.

Step 245, PCQ = VT*IAQ + ROQ*IRQ^2, may include calculating or determining a conductive transistor power (PCQ) of the transistor using Eq. 7,

$$PCQ = VSQ*IAQ + ROQ*IRQ^2, \qquad\qquad Eq. 7$$

where VSQ is the device forward conduction voltage drop based on a saturation voltage of the transistor 22, IAQ is an average current through the transistor 22 over one or more complete AC cycles of the inverter 10, ROQ is an on-resistance of the transistor 22, and IRQ is the AC RMS current through the transistor 22 over one over one or more complete AC cycles.

IAQ may be determined using Eq. 8, and IRQ may be determined using Eq. 9,

$$IAQ = IPQ * ((1/(2* \pi)) + (MI * PF / (2 * \pi))), \qquad\qquad Eq. 8$$

$$IRQ = IPQ * sqrt(0.125 + (4 * MI * PF / (3 * \pi^2))). \qquad\qquad Eq. 9$$

Step 250, PCD = VFD*IAD + ROD*IRD^2, may include calculating or determining a conductive diode power (PCD) of the transistor using Eq. 10,

$$PCD = VFD*IAD + ROD*IRD^2, \qquad\qquad Eq. 10$$

where VFD is the forward voltage drop of the diode 24, IAD is an average current through the diode 24 over one or more complete AC cycles of the inverter 10, ROD is an on-resistance of the diode 24, and IRD is the AC RMS current through the diode 24 over one or more complete AC cycles.

IAQ may be determined using Eq. 11, and IRQ may be determined using Eq. 12,

$$IAD = IPD * ((1/(2* \pi)) - (MI * PF / (2 * \pi))), \qquad\qquad Eq. 11$$

$$IRQ = IPQ * sqrt(0.125 - (4 * MI * PF / (3 * \pi^2))). \qquad\qquad Eq. 12$$

Step 255, PTOT = PSQ + PCQ + PSD + PCD, may include calculating or determining a total power dissipation (PTOT) for a driver stage (HSDA 16A, HSDB 16B, HSDC 16C LSDA 18A, LSDB 18B, or LSDC 18C) by adding together the switching and conductive power dissipations of the transistor 22 and the diode 24. The total power dissipated by the inverter 10 may be estimated by adding together the PTOTs for each driver stage.

Accordingly, a method 200 of to estimate power dissipation of an inverter is provided. The method provides an improved way to estimate power dissipation if the inverter 10 is being over-driven or operated in a non-linear region of operation.

**Claims**

1. A method (200) to estimate power dissipation of switched power losses in an inverter (10) configured to control electric energy to an electric machine (12), said method (200) comprising:

   determining (220, 235) a switched transistor power (PSQ) of a transistor (22) or a switched diode power (PSD) of a diode (24) based on a modulation frequency (FM), a peak current (IPQ, IPD) of current through the transistor (22) or the diode (24), a rail-to-rail inverter supply voltage (VS), and an switching energy (ESQ, ERD) of the switched transistor (22) or the switched diode (24) for each modulation cycle;
   determining (210) a modulation index (MI) of the inverter;
   recalling a stored (205) power factor value (PF) of the electric machine (12); **characterized in**
   determining (230) a correction factor (CF) for the PSQ or the PSD, wherein the CF is set to one if the MI is not greater than a threshold, and the CF is based on the MI and the absolute value of the PF if the MI is greater than the threshold; said threshold being an indication of whether the inverter is being operated in a linear range where there is no over-modulation of the inverter, and
   estimating (255) switched power losses of the transistor (22) or the diode (24) based on the PSQ or the PSD and on the CF.

2. The method (200) in accordance with claim 1, wherein the transistor (22) is one of an insulated gate bipolar transistor (IGBT), and a metal oxide semiconductor field effect transistor (MOSFET).

3. The method (200) according to any one of the preceding claims, wherein the switched transistor power (PSQ) is determined by the equation $PSQ = FM \cdot IPQ \cdot ESQ \cdot VS / \pi$.

4. The method (200) according to any one of the preceding claims, wherein the modulation index (MI) is determined by the equation $MI = (\pi / sqrt (2)) * (VP/VS)$, where VP is an AC RMS voltage applied to the electric machine (12) by the inverter (10), and VS is the rail-to-rail supply voltage of the inverter (10).

5. The method (200) according to any one of the preceding claims, wherein the correction factor (CF) is determined by the equation $CF = 8.752 - 8.5933*MI - 0.2280*|PF|$ if the MI is greater than the threshold.

6. The method (200) according to any one of the preceding claims, wherein the method (200) further comprises determining (245) a conductive transistor power (PCQ) of the transistor (22) based on a saturation voltage (VSQ) of the transistor (22), an on-resistance (ROQ) of the transistor (22), and current through the transistor (22).

7. The method (200) in accordance with claim 6, wherein the step of estimating power dissipation of the transistor (22) is further based on the PCQ.

8. The method (200) in accordance with claim 1, wherein said method (200) further comprises determining (225, 240) the switched diode power (PSD) of the diode (24) connected in parallel with the transistor (22), wherein the PSD is based on a modulation frequency (FM), the peak diode current (IPD) of current through the diode (24), the rail-to-rail inverter supply voltage (VS), and a diode reverse-recovery energy (ERD) of the diode (24) for each modulation cycle; estimating (255) switched power losses of the diode (24) based on the PSD and the CF.

9. The method (200) according to claim 8, wherein the switched diode power (PSD) is determined by the equation $PSD = FM \cdot IPD \cdot ERD \cdot VS / \pi$.

10. The method (200) according to any one of the preceding claims, wherein the

method (200) further comprises
determining (250) a conductive diode power (PCD) of the diode (24) based on a diode
saturation voltage (VSD), an on-resistance (ROD) of the diode (24), and current
through the diode (24).

11. The method (200) according to any one of the preceding claims, wherein the switched power losses of the inverter (10) is based on the power dissipation of the transistor (22) and the power dissipation of the diode (24).

12. Apparatus adapted to estimate power dissipation of switched power losses of an inverter (10), said inverter configured to control electric energy to an electric machine (12) comprising:

means for determining a switched power (PSQ, PSD) of a transistor (22) or a diode (24), said switched power (PSQ, PSD) being based on a modulation frequency (FM), a peak current (IPQ, IPD) of current through the transistor (22) or the diode (24), a rail-to-rail inverter supply voltage (VS), and an switching energy (ESQ, ERD) of the switched transistor (22) or the switched diode (24) for each modulation cycle;
means for determining a modulation index (MI) of the inverter (10);
means for recalling a stored (205) power factor value (PF) of the electrical machine (12);
**characterized in** having means for determining a correction factor (CF) for the PSQ or the PSD, wherein the CF is set to one if the MI is not greater than a threshold, and the CF is based on the MI and the absolute value of the PF if the MI is greater than the threshold; and
means for estimating switched power losses power dissipation of the transistor (22) or the diode (24) based on the PSQ or the PSD and on the CF.

## Patentansprüche

1. Verfahren (200) zum Schätzen einer Verlustleistung von Schaltleistungsverlusten in einem Inverter (10), der konfiguriert ist zum Steuern von elektrischer Energie an eine elektrische Maschine (12), wobei das Verfahren (200) aufweist:

Bestimmen (220, 235) einer Schalttransistorleistung (PSQ) eines Transistors (22) oder einer Schaltdiodenleistung (PSD) einer Diode (24) basierend auf einer Modulationsfrequenz (FM), einem Spitzenstrom (IPQ, IPD) von Strom durch den Transistor (22) oder die Diode (24), einer Rail-to-Rail-Inverter-Versorgungsspannung (VS) und einer Schaltenergie (ESQ, ERD) des Schalttransistors (22) oder der Schaltdiode (24) für jeden Modulationszyklus;
Bestimmen (210) eines Modulationsindex (MI) des Inverters;
Abrufen eines gespeicherten (205) Leistungsfaktorwerts (PF) der elektrischen Maschine (12); **gekennzeichnet durch**
Bestimmen (230) eines Korrekturfaktors (CF) für PSQ oder PSD, wobei der CF auf Eins gesetzt ist, wenn der MI nicht größer als eine Schwelle ist, und der CF auf dem MI und dem absoluten Wert von PF basiert, wenn MI größer ist als die Schwelle; wobei die Schwelle eine Angabe ist, ob der Inverter in einem linearen Bereich betrieben wird, wo es keine Übermodulation des Inverters gibt, und
Schätzen (255) von Schaltleistungsverlusten des Transistors (22) oder der Diode (24) basierend auf der PSQ oder der PSD und dem CF.

2. Das Verfahren (200) gemäß Anspruch 1, wobei der Transistor (22) einer aus einem Bipolartransistor mit isoliertem Gate (IGBT - insulated gate bipolar transistor) und einem Metalloxidhalbleiter-Feldeffekttransistor (MOSFET - metal oxide semiconductor field effect transistor) ist.

3. Das Verfahren (200) gemäß einem der vorhergehenden Ansprüche, wobei die Schalttransistorleistung (PSQ) durch die Gleichung $PSQ = FM \cdot IPQ \cdot ESQ \cdot VS / \pi$ bestimmt wird.

4. Das Verfahren (200) gemäß einem der vorhergehenden Ansprüche, wobei der Modulationsindex (MI) durch die Gleichung $MI = (\pi / \sqrt{2}) * (VP/VS)$ bestimmt wird, wobei VP eine AC-RMS-Spannung ist, die durch den Inverter (10) auf die elektrische Maschine (12) angewendet wird, und VS die Rail-to-Rail-Versorgungsspannung des Inverters (10) ist.

5. Das Verfahren (200) gemäß einem der vorhergehenden Ansprüche, wobei der Korrekturfaktor (CF) durch die Gleichung CF = 8,752 - 8,5933 * MI - 0,2280*|PF| bestimmt wird, wenn der MI größer als die Schwelle ist.

**6.** Das Verfahren (200) gemäß einem der vorhergehenden Ansprüche, wobei das Verfahren (200) weiter aufweist Bestimmen (245) einer leitenden Transistorleistung (PCQ) des Transistors (22) basierend auf einer Sättigungsspannung (VSQ) des Transistors (22), einem Ein-Widerstand (ROQ) des Transistors (22) und einem Strom durch den Transistor (22).

**7.** Das Verfahren (200) gemäß Anspruch 6, wobei der Schritt zum Schätzen der Verlustleistung des Transistors (22) weiter auf der PCQ basiert.

**8.** Das Verfahren (200) gemäß Anspruch 1, wobei das Verfahren (200) weiter aufweist Bestimmen (225, 240) der Schaltdiodenleistung (PSD) der Diode (24), die parallel zu dem Transistor (22) verbunden ist, wobei die PSD auf einer Modulationsfrequenz (FM), dem Spitzendiodenstrom (IPD) von Strom durch die Diode (24), der Rail-to-Rail-Inverter-Versorgungsspannung (VS) und einer Diode-Reverse-Recovery-Energie (ERD) der Diode (24) für jeden Modulationszyklus basiert; Schätzen (255) von Schaltleistungsverlusten der Diode (24) basierend auf PSD und CF.

**9.** Das Verfahren (200) gemäß Anspruch 8, wobei die Schaltdiodenleistung (PSD) durch die Gleichung PSD = FM · IPD · ERD · VS / $\pi$ bestimmt wird.

**10.** Das Verfahren (200) gemäß einem der vorhergehenden Ansprüche, wobei das Verfahren (200) weiter aufweist Bestimmen (250) einer leitenden Diodenleistung (PCD) der Diode (24) basierend auf einer Dioden-Sättigungsspannung (VSD), einem Ein-Widerstand (ROD) der Diode (24) und einem Strom durch die Diode (24).

**11.** Das Verfahren (200) gemäß einem der vorhergehenden Ansprüche, wobei die Schaltleistungsverluste des Inverters (10) auf der Verlustleistung des Transistors (22) und der Verlustleistung der Diode (24) basiert.

**12.** Vorrichtung, die ausgebildet ist zum Schätzen einer Verlustleistung von Schaltleistungsverlusten eines Inverters (10), wobei der Inverter konfiguriert ist zum Steuern einer elektrischen Energie an eine elektrische Maschine (12), aufweisend:

Mittel zum Bestimmen einer Schaltleistung (PSQ, PSD) eines Transistors (22) oder einer Diode (24), wobei die Schaltleistung (PSQ, PSD) basiert auf einer Modulationsfrequenz (FM), einem Spitzenstrom (IPQ, IPD) von Strom durch den Transistor (22) oder die Diode (24), einer Rail-to-Rail-Inverter-Versorgungsspannung (VS) und einer Schaltenergie (ESQ, ERD) des Schalttransistors (22) oder der Schaltdiode (24) für jeden Modulationszyklus;
Mittel zum Bestimmen eines Modulationsindex (MI) des Inverters (10);
Mittel zum Abrufen eines gespeicherten (205) Leistungsfaktorwerts (PF) der elektrischen Maschine (12);
**gekennzeichnet durch** Mittel zum Bestimmen eines Korrekturfaktors (CF) für PSQ oder PSD, wobei der CF auf Eins gesetzt ist, wenn der MI nicht größer als eine Schwelle ist, und der CF auf dem MI und dem absoluten Wert von PF basiert, wenn MI größer ist als die Schwelle; und
Mittel zum Schätzen einer Schaltleistungsverlusten-Verlustleistung des Transistors (22) oder der Diode (24) basierend auf der PSQ oder der PSD und dem CF.

## Revendications

**1.** Procédé (200) pour estimer la dissipation de puissance des pertes de puissance par commutation dans un inverseur (10) configuré pour commander l'énergie électrique vers une machine électrique (12), ledit procédé (200) comprenant les étapes consistant à :

déterminer (220, 235) une puissance de transistor commuté (PSQ) d'un transistor (22) ou une puissance de diode commutée (PSD) d'une diode (24) sur la base d'une fréquence de modulation (FM), d'un courant de pointe (IPQ, IPD) du courant à travers le transistor (22) ou la diode (24), d'une tension d'alimentation d'inverseur de rail-à-rail (VS), et une d'énergie de commutation (ESQ, ERD) du transistor commuté (22) ou de la diode commutée (24) pour chaque cycle de modulation ;
déterminer (210) un indice de modulation (MI) de l'inverseur ;
rappeler (205) une valeur stockée du facteur de puissance (PF) de la machine électrique (12) ;

**caractérisé par** les étapes consistant à

déterminer (230) un facteur de correction (CF) pour la puissance PSQ ou PSD, dans lequel le facteur de correction est fixé à la valeur un si l'indice de modulation n'est pas supérieur à un seuil, et le facteur de correction est basé sur l'indice de modulation, et à la valeur absolue du facteur de puissance si l'indice de modulation est supérieur au seuil ; ledit seuil étant une indication quant à savoir si l'inverseur est en fonctionnement dans une plage linéaire dans laquelle il n'y a pas de surmodulation de l'inverseur, et

estimer (255) sur perte de puissance par commutation du transistor (22) ou de la diode (24) en se basant sur la puissance PSQ ou PSD et sur le facteur de correction.

2. Procédé (200) selon la revendication, dans lequel le transistor (22) est soit un transistor bipolaire à grille isolée (IGBT) soit un transistor à effet de champ à semi-conducteur métal oxyde (MOSFET).

3. Procédé (200) selon l'une des revendications précédentes, dans lequel la puissance du transistor commuté (PSQ) est déterminée par l'équation

$$PSQ = FM \cdot IPQ \cdot ESQ \cdot VS/\pi.$$

4. Procédé (200) selon l'une quelconque des revendications précédentes, dans lequel l'indice de modulation (MI) est déterminé par l'équation

$$MI = (\pi/\text{sqrt}\ (2)) * (VP/VS)$$

dans laquelle VP est une tension alternative RMS appliquée à la machine électrique (12) par l'inverseur (10) et VS est la tension d'alimentation de rail-à-rail de l'inverseur (10).

5. Procédé (200) selon l'une quelconque des revendications précédentes, dans lequel le facteur de correction (CF) est déterminé par l'équation

$$CF = 8{,}752 - 8{,}5933* MI - 0{,}2280 * | PF |$$

si l'indice de modulation est supérieur au seuil.

6. Procédé (200) selon l'une quelconque des revendications précédentes, dans lequel le procédé (200) comprend en outre

l'étape consistant à déterminer (245) une puissance de transistor conducteur (PCQ) du transistor (22) sur la base d'une tension de saturation (VSQ) du transistor (22), d'une résistance en marche (ROQ) du transistor (22), et du courant à travers le transistor (22).

7. Procédé (200) selon la revendication 6, dans lequel l'étape consistant à estimer la dissipation de puissance du transistor (22) est en outre basé sur la puissance PCQ.

8. Procédé (200) selon la revendication 1, dans lequel ledit procédé (200) comprend en outre les étapes consistant à déterminer (225, 240) la puissance de diode commutée (PSD) de la diode (24) connectée en parallèle avec le transistor (22), dans laquelle la puissance PSD est basée sur une fréquence de modulation (FM), sur le courant de pointe de la diode (IPD) du courant à travers la diode (24), de la tension d'alimentation d'inverseur de rail-à-rail (VS), et d'une énergie de récupération inverse de diode (ERD) de la diode (24) pour chaque cycle de modulation ; estimer (255) les pertes de puissance par commutation de la diode (24) sur la base de la puissance PSD et du facteur de correction.

9. Procédé (200) selon la revendication 8, dans lequel la puissance de diode commutée (PSD) est déterminée par l'équation

$$PSD = FM \cdot IPD \cdot ERD \cdot VS/\pi.$$

**10.** Procédé (200) selon l'une quelconque des revendications précédentes, dans lequel le procédé (200) comprend en outre

l'étape consistant à déterminer (250) une puissance de diode conductrice (PCD) de la diode (24) sur la base d'une tension de saturation de diode (VSD), d'une résistance en marche (ROD) de la diode (24), et du courant à travers la diode (24).

**11.** Procédé (200) selon l'une quelconque des revendications précédentes, dans lequel les pertes de puissance par commutation de l'inverseur (10) sont basées sur la dissipation de puissance du transistor (22) et sur la dissipation de puissance de la diode (24).

**12.** Appareil, adapté pour estimer la dissipation de puissance des pertes de puissance par commutation d'un inverseur (10), ledit inverseur étant configuré pour commander l'énergie électrique à une machine électrique (12), comprenant :

un moyen pour déterminer la puissance commutée (PSQ, PSD) d'un transistor (22) ou d'une diode (24), ladite puissance commutée (PSQ, PSD) étant basée sur une fréquence de modulation (FM), sur un courant de pointe (IPQ, IPD) du courant à travers le transistor (22) ou la diode (24), sur une tension d'alimentation d'inverseur de rail-à-rail (VS), et sur une énergie de commutation (ESQ, ERD) du transistor commuté (22) ou de la diode commutée (24) pour chaque cycle de modulation ;

un moyen pour déterminer un indice de modulation (MI) de l'inverseur (10) ;

un moyen pour rappeler une valeur stockée (205) du facteur de puissance (PF) de la machine électrique (12) ; **caractérisé en ce qu'**il comprend un moyen pour déterminer un facteur de correction (CF) pour la puissance PSQ ou PSD, dans lequel le facteur de correction est fixé à la valeur un si l'indice de modulation n'est pas supérieur à un seuil, et le facteur de correction est basé sur l'indice de modulation et à la valeur absolue du facteur de puissance si l'indice de modulation est supérieur au seuil ; et

un moyen pour estimer la dissipation de puissance des pertes de puissance par commutation du transistor (22) ou de la diode (24) sur la base de la puissance PSQ ou PSD et du facteur de correction.

**FIG. 1**

FIG. 2

EP 2 816 722 B1

**Patent documents cited in the description**

- EP 2398140 A

**Non-patent literature cited in the description**

- **LIXIANG WEI et al.** Evaluation of Power Semiconductors Power Cycling Capabilities for Adjusting Speed Drive. *Inductrial Applications Society Annual Meeting, 2008. IAS '08,* 05 October 2008
- **DUSAN GRAOVAC ; MARCO PURSCHEL ; ANDREAS KIEP.** MOSFET Power losses Calculation Using the Data -Sheet parameters. Infineon Technologies AG, 31 July 2006
- Carrier Based PWM-VSI Overmodulation Strategies: Analysis, Comparison, and Design. **AHMET M HAVA et al.** IEEE Transaction on Power Electronics. IEEE, 01 July 1998, vol. 13